(19) Europäisches Patentamt
European Patent Office
Office européen des brevets

(11) **EP 3 091 307 A1**

(12) **EUROPEAN PATENT APPLICATION**
published in accordance with Art. 153(4) EPC

(43) Date of publication:
**09.11.2016 Bulletin 2016/45**

(51) Int Cl.:
*F24J 2/07* [(2006.01)]     *G02B 5/28* [(2006.01)]
*H01L 31/054* [(2014.01)]     *H02S 40/44* [(2014.01)]

(21) Application number: **14835664.5**

(86) International application number:
**PCT/ES2014/070999**

(22) Date of filing: **31.12.2014**

(87) International publication number:
**WO 2015/101692 (09.07.2015 Gazette 2015/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.12.2013 ES 201331946**

(71) Applicant: **Abengoa Solar New Technologies, S.A. 41014 Sevilla (ES)**

(72) Inventors:
• **NORIEGA GIL, Pablo E-41014 Sevilla (ES)**

• **CAPARRÓS JIMÉNEZ, Sebastián E-41014 Sevilla (ES)**
• **CASTAÑO SÁNCHEZ, Fernando Jesús E-41014 Sevilla (ES)**
• **NUÑEZ BOOTELLO, Juan Pablo E-41014 Sevilla (ES)**
• **DE DIOS PARDO, Antonio E-41014 Sevilla (ES)**
• **BOYLE, Keith E-41014 Sevilla (ES)**

(74) Representative: **Elzaburu S.L.P. C/ Miguel Angel, 21 28010 Madrid (ES)**

(54) **HYBRID SYSTEM COMPRISING A THERMOSOLAR PARAMETRIC CYLINDER AND A PHOTOVOLTAIC RECEIVER**

(57)     Hybrid system of parametric solar thermal cylinder (14) and photovoltaic receiver (3), which comprises a thermal absorber receiver (2) through which a heat-carrier fluid circulates, and, additionally at least one spectral separation filter (4), situated between the photovoltaic receiver (3) and the thermal absorber receiver (2), which receives the light reflected from the primary mirror (1) of the parametric cylinder (14) and which permits the selective separation of the solar spectrum, directing a part thereof towards the photovoltaic receiver (3) and the remainder towards the thermal absorber receiver.

FIG. 1

**Description**

**Field of the invention**

This invention refers to a hybrid system of parametric cylinder solar thermal receivers and photovoltaic receivers in an integrated solar concentration system.

**Background of the invention**

Solar concentration technology is divided into two main blocks: solar thermal concentration and photovoltaic solar concentration.

The operating principle of both systems is based on the same concept: using an optical system that concentrates light. Said concentrated light can be directed to heat a fluid which enters a turbine cycle in the case of thermal systems, or directly generates electricity through photoelectric effect on a semiconductor in the case of photovoltaic systems.

Photovoltaic concentration technology consists of concentrating levels of solar radiation on cells of very reduced size. The use of a much cheaper optical element to concentrate incident light allows the use of more efficient solar cells (which are also generally more expensive). These systems can be potentially more competitive in terms of cost compared with conventional photovoltaic systems, as they largely replace the semiconductor area with standard optical elements such as lenses or mirrors, as well as being more efficient.

The combination of both reflexive and refractive elements gives rise to a wide variety of solar concentration systems. Nevertheless, in most photovoltaic concentration systems Fresnel lenses have been used with secondary concentration elements, double-mirror systems with light homogenisers or dielectric or, either mirrored or dielectric CPC (compound parabolic concentrators) systems.

Therefore, in the field of solar thermal concentration systems, two technologies currently dominate the market, namely the parabolic cylinder and the tower.

In particular, parabolic cylinder technology consists of a parabolic mirror which focuses the light on an absorber tube through which a heat-carrier fluid circulates. Said fluid heats up and is subsequently used to heat the steam used in a traditional turbine cycle.

At the present time, electricity production using solar thermal concentration plants is not, from a financial point of view, among the most competitive of the renewable technologies designed to obtain electrical power from the sun. Plants with solar thermal concentration (either parabolic cylinders or towers) have higher energy production costs than those associated with photovoltaic or wind energy systems. However, solar thermal concentration systems have a competitive advantage in that they are able to operate with thermal storage. Said storage provides manageability, as well as electricity supply during the time slots when electricity consumption is at its highest. This presupposes a differentiating factor in solar thermal technology compared with, for example, wind or photovoltaic technologies.

In the case of photovoltaic solar concentration, more efficient and economical systems are obtained than those of solar thermal concentration, however they have the disadvantage of being less manageable and they cannot store energy in a cost-efficient and effective manner, compared with solar thermal technology.

The document described in US 2009/0283144 A1 provides a device with one or several photovoltaic solar cells and at least one solar concentration mirror situated in the vicinity of the solar cells. The mirror comprises a multilayer optical film and a layer of UV protection applied on the previous film in such a way that the solar concentrator reflects a band of the visible spectrum (that corresponding to the absorption bandwidth of the solar cell) towards the solar cell, and transmits the wavelengths that may degrade or negatively affect the solar cell. Thus, improved functioning of photovoltaic solar cells is obtained.

In respect of hybrid photovoltaic-solar thermal systems, scientific literature contains several concepts which use spectral separation in order to obtain improved use of the solar spectrum by combining solar thermal collectors and solar cells. However, integrating solar thermal and photovoltaic technologies in a single hybrid solar concentration system is not an easy task. Some proposals refer to spectral separation systems applied to a system with Stirling dishes and engines.

It is therefore necessary to obtain a hybrid photovoltaic-solar thermal system which resolves the aforementioned disadvantages, so that the integrated system is characterised by lower cost than standard solar thermal technology, due to the inclusion of the photovoltaic part working very efficiently in the selective spectral range, and which, in addition, is manageable, providing energy in a stable manner and during the time slots when it is really needed.

**Summary of the invention**

Therefore, the purpose of the invention is to provide a hybrid system of parametric solar thermal cylinder and photovoltaic receiver which allows storage and manageability of the energy with lower production costs than standard solar thermal technology, providing a more efficient integrated solar concentration system.

The hybrid system of parametric solar thermal cylinder and photovoltaic receiver in this invention comprises a thermal absorber receiver through which a heat-carrier fluid circulates, and additionally at least one spectral separation filter between the photovoltaic receiver and the thermal absorber receiver, which receives the light reflected from the primary mirror of the parametric cylinder and which allows selective separation of the solar spectrum, directing a part thereof towards the photovoltaic receiver and the rest towards the parametric cylinder.

According to an embodiment of the invention, the part of the solar spectrum directed towards the photovoltaic receiver is the part reflected by the spectral separation filter and the part of the solar spectrum directed towards the thermal absorber receiver is the part transmitted by the spectral separation filter.

According to another embodiment of the invention, the part of the solar spectrum directed towards the photovoltaic receiver is the part transmitted by the spectral separation filter and the part of the solar spectrum directed towards the thermal absorber receiver is the part reflected by the spectral separation filter.

The spectral separation filter therefore allows selective separation of the solar spectrum in such a way that the radiation bands are directed selectively to each of the receivers (thermal and photovoltaic). The spectral range of the part focused on the photovoltaic receiver is situated specifically in the band where the solar cell operates with the best performance. This results in a more efficient integrated system in which costs are optimised.

The hybrid system in this invention has the following advantages:

- Better use is made of solar radiation with respect to traditional photovoltaic systems or those with separate solar thermal concentration.
- The integrated system obtained is more manageable compared with other traditional photovoltaic systems or those with photovoltaic concentration.

Therefore, the result is a solution that is economically more profitable, in which power is manageable and all the advantages of renewable energies are retained (reduction of greenhouse gases, pollution etc.).

Other characteristics and advantages of this invention will be disclosed in the following detailed description of the illustrative and non-limiting embodiment of its purpose in relation to the figures attached hereto.

**BRIEF DESCRIPTION OF THE FIGURES**

Fig. 1: shows a diagram of the invention according to an embodiment, referred to hereinafter as direct configuration.

Fig. 2: shows a diagram of the invention according to another embodiment, referred to hereinafter as inverse configuration.

Fig. 3: shows a diagram of another embodiment of the invention.

Fig. 4: shows a diagram of another embodiment of the invention.

Fig. 5: shows a diagram of the functioning of the spectral separation filter.

Fig. 6: shows a diagram of the architecture of the spectral separation filter.

Fig. 7: System of thermal management using extruded heat sink with transversal orientation.

Fig. 8: System of thermal management using extruded heat sink with parallel orientation.

Fig. 9: System of thermal management using extruded heat sink which encourages internal air flow with parallel orientation.

Fig. 10: System of thermal management using a heat pipe.

Fig. 11: System of thermal management by means of active cooling circuit.

Fig. 12: Transmission curve of the spectral separation filter in direct configuration.

Fig. 13: Transmission curve of the spectral separation filter in inverse configuration.

Fig. 14: Alternative system of thermal management by means of an active cooling circuit comprising pumps, fans, and pipes through which the cooling fluid flows.

Fig. 15: Pipes or ducts through which the cooling fluid of the system flows in Fig. 14

Figs. 16 and 17: Photovoltaic receiver with the pipe of figure 15 incorporated.

Fig. 18: Transmission curve of the spectral separation filter with aperiodic design.

Fig. 19: Diagram of the architecture of the spectral separation filter in Fig. 18

**Detailed description of the invention**

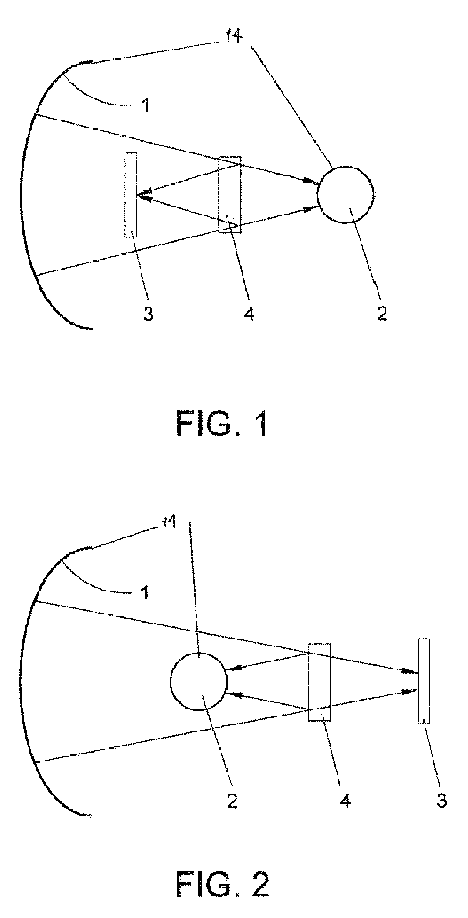

Figure 1 shows an embodiment of the invention. The hybrid system in this embodiment of the invention comprises:

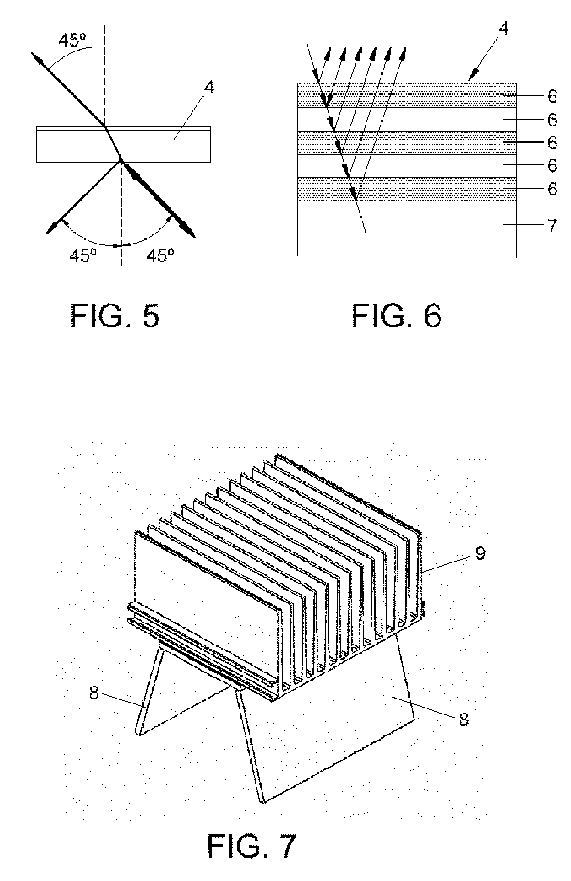

- A primary mirror 1 which focuses light and is preferably in a parabolic shape.
- A spectral separation filter 4, which will reflect a specific band of the useful visible spectrum for the photovoltaic receiver 3 which will be described below and which will transmit the remaining wavelengths. Figure 5 conceptually shows the functioning of the spectral separation filter 4. This element shall be manufactured preferably by depositing multi-layers of transparent oxides with a low/high refractive rate, which would filter the spectrum as shown in the diagram in figure 6.
- A thermal absorber receiver 2, which will preferentially capture the spectrum bands with shorter and longer wavelengths than the visible band reflected.
- A photovoltaic receiver 3, which will preferentially capture wavelengths in the visible spectrum. Said photovoltaic receiver 3 may comprise:

    ◦ Re-concentrating mirrors 8.
    ◦ Interconnected photovoltaic solar cells 12.
    ◦ Glass substrates for protecting the cells and internal elements of the photovoltaic receiver 3.
    ◦ Encapsulating materials
    ◦ Thermal management systems, comprising:

    -    a material which insulates the system electrically and transfers the heat generated in the cell 12 towards the heat sink, and
    -    a thermal management system. There are various options such as heat sinks manufactured by extrusion, heat pipes, or active cooling circuits.

The parametric cylinder 14 will comprise as a minimum the primary mirror 1 and the thermal absorber receiver 2.
In the embodiment of figure 1 the thermal absorber receiver 2 is placed on the spectral separation filter 4, and the photovoltaic receiver 3 below said filter 4. This arrangement allows the light reflected by the primary mirror 1 of the parametric cylinder 14 to selectively separate in the spectral separation filter 4, such that the part reflected by said filter 4 is directed towards the photovoltaic receiver 3, and the part transmitted by said filter 4 is directed towards the thermal absorber receiver 2.

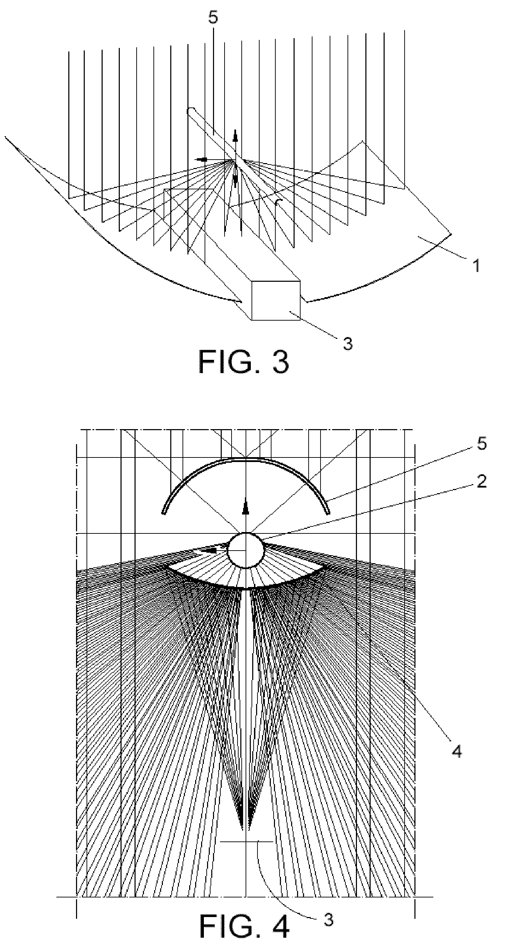

Figure 3 shows an embodiment in which the photovoltaic receiver 3 is placed on the primary mirror 1 of the parametric cylinder 14.
As a design alternative there is an inverse option in which the part transmitted is directed to the photovoltaic receiver 3 (see figure 2). In the embodiment of figure 2 the thermal absorber receiver 2 is placed beneath the spectral separation filter 4, and the photovoltaic receiver 3 on top of said filter 4. This arrangement allows the light reflected by the primary mirror 1 of the parametric cylinder 14 to be selectively separated in the spectral separation filter 4, so that the part reflected by said filter 4 is directed towards the photovoltaic receiver 3, and the part transmitted by said filter 4 is directed towards the thermal absorber receiver 2.
Figure 4 shows an embodiment of the invention in which the system optionally includes a reflector or secondary collector 5 which re-concentrates light directly onto the thermal absorber receiver 2, and which permits an increase in the area of aperture of the primary and, consequently, the temperature at which said receiver could operate. For the purposes of simplification, primary mirror 1 has not been represented.

Figure 3 also shows the reflector or secondary collector 5 of figure 4, although for the purpose of simplification some elements of the invention in figure 3 have been omitted.

The system in this invention may present several filters of spectral separation 4 and various photovoltaic receivers 3. In this way the range of light to the thermal absorber receiver 2 would be removed, which could be less efficient.

The primary mirror 1 of the parametric cylinder 14 may be made from curved glass and have a reflecting surface manufactured in silver or aluminium. It may also be made from any reflective material.

The spectral separation filter 4 may be curved, flat or faceted, and shall be optimised in order to work on transferring/reflecting light in the range which maximises the efficiency of the photovoltaic receiver 3.

Figure 5 shows a diagram of the functioning of a spectral separation filter 4, in which part of the light is reflected and part is transmitted, and figure 6 shows a diagram of its architecture, with various layers 6 situated on a substrate 7.

The preferred method for manufacturing filters 4 is through sputtering. Said technique is a physical process in which atoms are vaporised from a solid material known as a "target", which is bombarded with energetic ions. The layers of transparent oxides are combined with different refractive index and thickness. Said refractive index and thickness of layers allows determination of the optical path that the light will take, thus determining the transmission/reflectance conduct presented, depending on the incident wavelength.

There are other filter manufacturing methods such as evaporation or immersion techniques (dip coating) using sol-gel techniques. Evaporation consists of the passage from liquid phase to gas of a material deposited in the substrate, normally a solar grade glass. In dip coating, the substrate is submerged in solutions, depositing the desired layer, and subsequently subjecting it to partial curing. This process of deposition and immersion may be repeated as often as necessary to obtain the desired structure.

The cooling or heat management system of the photovoltaic receiver 3 may be passive (aluminium heat sinks 9 produced through different manufacturing processes, heat pipes or product transfer pipes (circulation of a fluid).

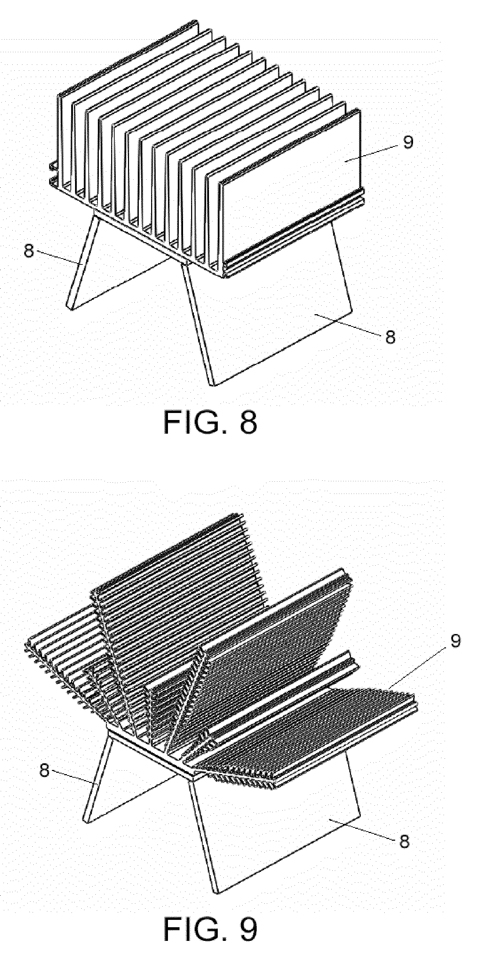

Figures 7, 8 and 9 show various configurations of heat management systems using heat sinks 9 manufactured through extrusion processes. These heat sinks may be oriented transversally towards the cell 12 (figure 7) or in parallel (figures 8 and 9).

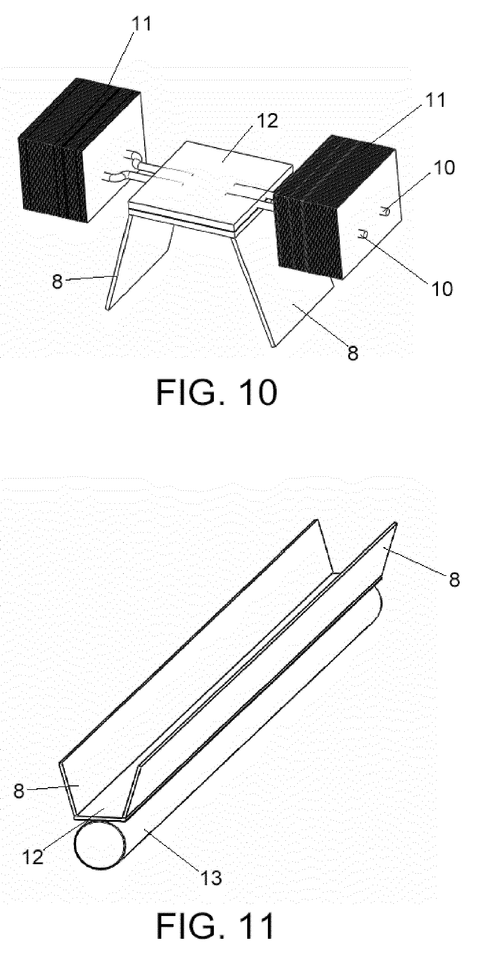

Figure 10 shows a system of thermal management using heat pipes. A heat pipe is a passive system of heat evacuation. It consists of a sealed pipe 10 with a material that adheres to its walls and which contains a fluid inside. The heat is evacuated through a change in the vapour-liquid phase. The pipe consists of three differentiated sections: the evaporation section, the adiabatic section and the condensation section. The heat is transferred from the surface to be cooled to the evaporator where the fluid contained inside the pipe 10 is vaporised and the steam rises through the same, passing through the adiabatic section until it enters a condensation section in which said vapour is condensed. The material adhering to the walls of the pipe 10 generates capillarity forces on the working fluid of the heat transfer pipe and encourages movement of the fluid from the condenser to the evaporator. By means of this system, a very effective heat transmission is guaranteed from the heat generating source (photovoltaic cell) to the heat dissipation fins 11. This is a sealed means of contention, with no need for pumping, and in which the fluid used will preferably be water. It may be designed to cool solar cells which are required to work at temperatures below a maximum temperature of some 60°-70°C in order to maintain its efficiency.

The fluid to be chosen for use inside will depend on the temperature range of the functioning of the heat transfer pipe and also the material used for construction of the pipe 10 material, those most frequently used include: helium, nitrogen, ammonia, acetone, methanol, ethanol, water, toluene, mercury, sodium, lithium and silver.
The most frequently used materials for construction of the pipes 10 are copper, nickel, steel, aluminium, niobium, tungsten, and alloys of these metals.

Figure 11 shows a system of thermal management by means of active cooling circuit 13. Said circuit 13 would use water or other cooling liquid which circulates in contact with the back part of the photovoltaic receiver 3. Said fluid heats up as it passes through the length of pipe, cooling the solar cell 12. This is the most efficient system of thermal dissipation, however it implies fluids in permanent movement in addition to the apparatus needed to move them, such as pumps.

The pipe used in the circuit 13 of figure 11 may be steel or aluminium and with a diameter between 50 and 200 mm. With respect to length, this will be defined according to the length of the photovoltaic receiver 3. The pipe could have a flat face designed to improve heat transmission in the area of contact with the photovoltaic receiver 3.

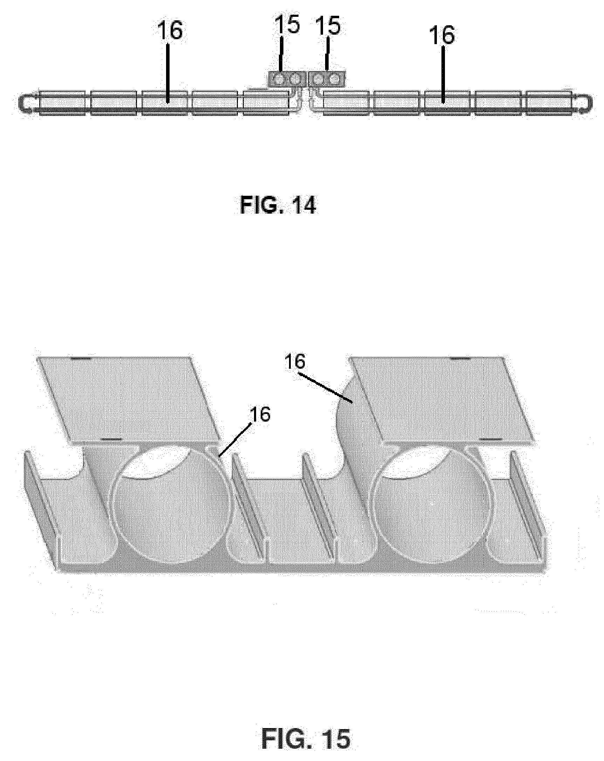

Another preferred embodiment of a system of heat management using an active cooling circuit is shown in figures 14 to 17. The system is formed by at least one pump, at least one fan 15 and at least one pipe 16 through which the cooling fluid flows (figure 14). In an embodiment, the pipe would have a diameter of 45mm and a cooling fluid flow of 1.8 kg/sec. would circulate through its interior

Preferably the cooling system will be active. The pump (or pumps) propels the cooling fluid that circulates through the pipes 16 and the fans 15 cooling the hot fluid proceeding from the cooling circuit. By way of example, the cooling fluid could be a mixture of water and glycol at 50% in weight with the following temperatures in a specific application:

T1 (outlet of the fan/entrance of the circuit): 60°C

T2 (halfway through the circuit): 71.5°C

T3 (outlet of the fan/entrance of the circuit): 75.2°C

Figure 15 shows the pipes 16 (which may be made from aluminium, for example) which allow circulation of the cooling fluid in closed circuit. As this is a linear system formed by discrete parts, it is necessary to use sealing means for their connection such as for example, sealing gaskets. A discrete part has a finite length. As a parabolic cylinder collector is relatively long, it is necessary to join these discrete parts using sealed joints if active dissipation is used.

The pipes 16 may be extruded parts, and they may be multi-channel, that is with at least one channel through which the cooling fluid flows.

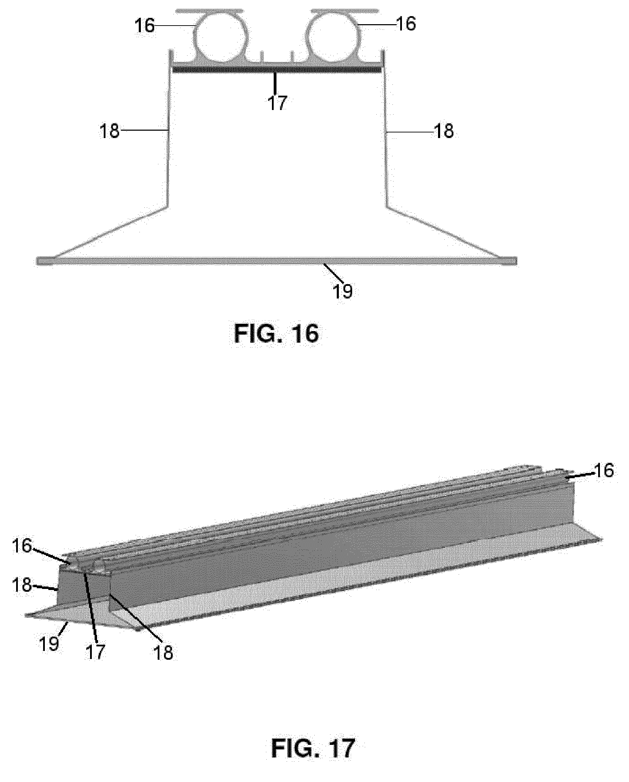

Figures 16 and 17 show the complete apparatus of the pipe 16 with the photovoltaic receiver. These figures show the photovoltaic cell 17 of the receiver. The lateral elements consist of the homogeniser 18 and the filter 19 is situated in the lower part. All of which is joined and sealed with an adhesive (for example, silicone).

In respect of the spectral separation filters 4, their design is determined by the direct or inverse configuration of the system.

The materials of the filters 4 are preferably transparent glass substrates, multi layers of transparent oxide conductors such as silica oxide or niobium oxide, transparent materials in the visible part and reflectors in the infra-red (by way of example we could cite layers of transparent oxides such as ITO), passivation layer and anti-reflecting layer. The filter 4 may include all or some of the aforementioned layers.

The passivation layer is a barrier layer which reduces diffusion of the glass component (impurities such as NA) to the multi-layer of transparent oxides.

Preferably, the number of layers of the complete filter 4 (of the oxide part) would be 1 to 200. It would be even more preferable for these to be 4 to 100, and ideally from 5 to 20.

The anti-reflective layer may be found at the two ends of the filter 4 or only at one end. Normally it will be on the side where the solar radiation occurs. Preferably these shall be silica oxide layers as they have a low refractive index. It is desirable for the refractive index of these layers to be intermediate between the glass and the air.

In the event of direct configuration a filter 4 should be obtained which provides:

• Maximum reflectance in a range (reflection band) 550-950 nm.

• Maximum transmittance in a range 300-550 nm and 950-2500 nm.

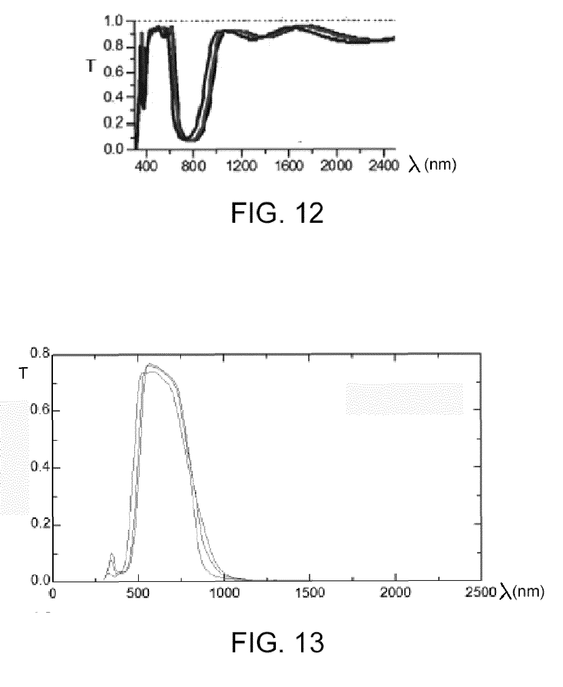

Figure 12 shows the design and optical conduct at different angles of incidence of a spectral separation filter in accordance with the requirements described.

As may be seen in the figure, the design of the filter 4 is defined by the following sequence

$$200L/V/100L\ /48H/(145L/85H)x3/280L$$

With V being glass, H transparent niobium oxide with a high refractive index (n_H=2.30) and L transparent silica oxide with a low refractory index (n_L=1.43). The numbers preceding each of these materials refer to the thickness of the layer of material (in nanometres). In this particular design, the layer (145U85H) is repeated three times.

The oxide layers may vary in the following ranges of thickness: from 1 to 1000 nm and, preferably from 5 to 400 nm.

The two outermost layers 200L and 280L are proposed as anti-reflecting layers of the structure. In the event of inverse configuration, a filter 4 should be obtained which provides:

• Maximum transmittance in a range (reflection band) 550-950 nm.

• Maximum reflectance between 400 -550 nm and 950-2500nm

Figure 13 shows the design and optical conduct of a spectral separation filter in accordance with the requirements described.

## V/M/90L/25H/(75L/42H)x3/150L

With V being glass, H transparent niobium oxide with a high refractive index (n_H=2.30) and L transparent silica oxide with a low refractory index (n_L=1.43) and M is a transparent material in the visible and reflecting parts in the IR. By way of example there are many transparent oxides such as the ITO which may comply with this function, without being restricted to use of these materials.

There is also the alternative of removing the material M and using simply transparent glass. In this case a multi-layer UH would need to be added in order to reflect radiation in the range of 950-1300 nm.

The outermost 150L is proposed as a passivation and anti-reflecting layer (AR) of the structure. The passivation layer is a barrier layer which reduces diffusion of the glass component to the multi-layer of transparent oxides.

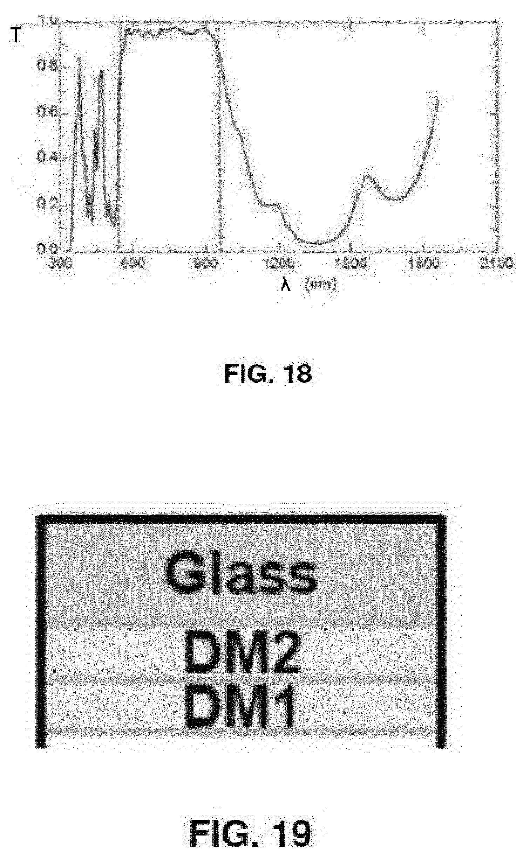

Figure 18 shows the optical conduct of another spectral separation filter 4, which is applicable in concentration systems subject to high temperatures and solar degradation because it does not degrade. In this case the filter is an aperiodic design defined by the following sequence:

## 130L/(162H/262L/164H/261L/159H/250L)/(156H/212L/123H/208L/127H/196L)/142H/ 249L/Glass/114L

in which L is $SiO_2$, H is $Nb_2O_5$, and in which the numbers that precede each of the materials refer to the thickness of the layer of said material in nanometres. The outer layer, $SiO_2$ with a thickness of 114 nm is proposed as an anti-reflecting layer of the structure.

The filter is very efficient in the IR and transmits between 500 -950 nm. In the zone of 550 nm downwards there are third order interferences. This means that the curve oscillates between high and low transmission values.

Tertiary interferences below 500 nm would not be a problem, as it is light which could be adequately made use of by both receivers, thus it does not affect the global efficiency of the system.

Figure 19 shows a diagram of the spectral separation filter architecture the optical conduct of which is represented in figure 18, where DM2 is (156H/212L/123H/208L/127H/196L) and DM1 is (162H/262L/164H/261L/159H/250L).

The use of an aperiodic design improves the conduct of the filter. Basically, making aperiodic layers enables secondary interferences that occur below 550 nm to be mitigated. The aim is to ensure that the filter behaves as in IR below 550nm (reflecting above) and this is obtained due to the aperiodic design with a reduced number of layers.

Below a preferred embodiment is described for a hybrid photovoltaic-solar thermal system, which would correspond to figure 2.

Said system would be formed by a parametric cylinder 14, with an aperture of 8.2m and a focal distance of 2.235m (with the focal distance being the distance between the primary mirror 1 of the parametric cylinder 14 and the photovoltaic receiver 3). The spectral separation filter 4 would reflect the light in an absorber receiver pipe 2 of 70 mm diameter. The spectral separation filter 4 is positioned at a distance of less than 100 mm from the pipe, which would preferably transmit light within a range of 500 to 950 nm to the photovoltaic receiver 3.

A thermal receiver 2 would be positioned in the reflected light focus, with a diameter of 90mm.

With respect to the spectral separation filter 4, a structure defined by the following sequence is proposed

## M /90L/25H/(75L/42H)x3

With H being transparent niobium oxide with a high refractive index (n_H=2.30) and L transparent silica oxide with a low refractory index (n_L=1.43) and M is a transparent material in the visible and reflecting part in the IR.

There is also the alternative of removing the material M and simply using transparent glass. In this case a multi-layer L/H would need to be added in order to reflect radiation in the range of 950-1300 nm.

For the material H, $TiO_2$ y $Nb_2O_5$, could preferably be used in order to be deposited with $SiO_2$, due to the difference of refractive index between them. The structure of layers may vary between 5 and 100 , depending on the performance that can be obtained from the filter.

Optionally at the ends of the multilayer structure, a barrier layer of diffusion of components can be deposited between the glass and the multilayer, in addition to anti-reflecting layers in the other end, together with a hard layer which protects the structure from abrasive agents.

The glass on which the multilayer is to be deposited could be composed of an anti-reflecting layer deposited on one or two faces.

Although this invention has been described here entirely in connection with preferred embodiments, it is evident that modifications could be introduced within the scope of the following claims, without said scope being limited by the aforementioned embodiments.

**Claims**

1. Hybrid system of parametric solar thermal cylinder (14) and photovoltaic receiver (3), which comprises a thermal absorber receiver (2) through which a heat transporting fluid circulates, **characterised in that**, additionally at least one spectral separation filter (4) is situated between the photovoltaic receiver (3) and the thermal absorber receiver (2), which receives the light reflected from the primary mirror (1) of the parametric solar thermal cylinder (14) and which permits the selective separation of the solar spectrum directing a part thereof towards the photovoltaic receiver (3) and the rest towards the thermal absorber receiver.

2. Hybrid system of parametric solar thermal cylinder (14) and photovoltaic receiver (3), according to claim 1, **characterised in that** the part of the solar spectrum directed towards the photovoltaic receiver (3) is the part reflected by the spectral separation filter (4) and the part of the solar spectrum directed towards the thermal absorber receiver (2) is the part transmitted by the spectral separation filter (4).

3. Hybrid system of parametric solar thermal cylinder (14) and photovoltaic receiver (3), according to claim 1, **characterised in that** the part of the solar spectrum directed towards the photovoltaic receiver (3) is the part transmitted by the spectral separation filter (4) and the part of the solar spectrum directed towards the thermal absorber receiver (2) is the part reflected by the spectral separation filter (4).

4. Hybrid system of parametric solar thermal cylinder (14) and photovoltaic receiver (3), according to claims 1 or 2, **characterised in that** the photovoltaic receiver (3) is situated on the primary mirror (1) of the parametric solar thermal cylinder.

5. Hybrid system of parametric solar thermal cylinder (14) and photovoltaic receiver (3), according to any of the previous claims, **characterised in that** additionally it comprises a secondary collector (5) which re-concentrates the light on the thermal absorber receiver (2).

6. Hybrid system of parametric solar thermal cylinder (14) and photovoltaic receiver (3), according to any of the previous claims, **characterised in that** it comprises various spectral separation filters (4) and various photovoltaic receivers (3).

7. Hybrid system of parametric solar thermal cylinder (14) and photovoltaic receiver (3), according to any of the previous claims, **characterised in that** the primary mirror (1) of the parametric cylinder may be made of curved glass.

8. Hybrid system of parametric solar thermal cylinder (14) and photovoltaic receiver (3), according to any of the previous claims, **characterised in that** the reflecting surface of the primary mirror (1) of the parametric cylinder may be made of silver or aluminium.

9. Hybrid system of parametric solar thermal cylinder (14) and photovoltaic receiver (3), according to any of the previous claims, **characterised in that** at least one spectral separation filter (4) may be curved, flat or faceted (3).

10. Hybrid system of parametric solar thermal cylinder (14) and photovoltaic receiver (3), according to any of the previous claims, **characterised in that** the photovoltaic receiver (3) comprises:

    - glass
    - encapsulants
    - interconnected photovoltaic cells (12) and
    - a thermal management system.

11. Hybrid system of parametric solar thermal cylinder (14) and photovoltaic receiver (3), according to claim 10, **characterised in that** the photovoltaic receiver (3) additionally comprises re-concentrating mirrors(8).

12. Hybrid system of parametric solar thermal cylinder (14) and photovoltaic receiver (3), according to claim 10 or 11, **characterised in that** the thermal management system of the photovoltaic receiver (3) is a passive system, as well as a system of extruded aluminium heat sinks (9).

13. Hybrid system of parametric solar thermal cylinder (14) and photovoltaic receiver (3), according to claim 10 or 11, **characterised in that** the thermal management system of the photovoltaic receiver (3) is an active system, with a circuit (13) through which cooling fluid circulates.

14. Hybrid system of parametric solar thermal cylinder (14) and photovoltaic receiver (3), according to claim 13, **characterised in that** the cooling fluid is water.

15. Hybrid system of parametric solar thermal cylinder (14) and photovoltaic receiver (3), according to claim 10 or 11, **characterised in that** the thermal management system of the photovoltaic receiver (3) is a heat transfer pipe system, consisting of a sealed pipe (10) with a material adhering to its walls and which contains fluid in its interior.

16. Hybrid system of parametric solar thermal cylinder (14) and photovoltaic receiver (3), according to any of the previous claims, **characterised in that** the spectral separation filter (4) comprises an anti-reflective layer of passivation, glass and a multilayer of transparent conductor oxides.

17. Hybrid system of parametric solar thermal cylinder (14) and photovoltaic receiver (3), according to any of claims 2 and 4 to 16, **characterised in that** the spectral separation filter (4) is a filter with maximum reflectance between 550 and 950 nm, and maximum transmittance between 300 and 550 nm and between 950 and 2500 nm.

18. Hybrid system of parametric solar thermal cylinder (14) and photovoltaic receiver (3), according to claim 17, **characterised in that** the spectral separation filter (4) is defined by the following sequence:

$$200L/V/100L\ /48H/(145L/85H)x3/280L$$

with V being glass, H transparent niobium oxide with a high refractive index ($n\_H=2,30$) and L being transparent silica oxide with a low refractive index ($n\_L=1,43$), and in which the numbers preceding each of the materials refer to the thickness of the layer of said material (in nanometres) with the layer being repeated (145L/85H) three times.

19. Hybrid system of parametric solar thermal cylinder (14) and photovoltaic receiver (3), according to any of claims 3 to 16, **characterised in that** the spectral separation filter (4) is a filter with maximum reflectance between 400 and 550 nm, and maximum transmittance between 550 and 950 nm.

20. Hybrid system of parametric solar thermal cylinder (14) and photovoltaic receiver (3), according to claim 19, **characterised in that** the spectral separation filter (4) is defined by the following sequence:

$$V/M/90L/25H/(75L/42H)x3/150L$$

with V being glass, H transparent niobium oxide with a high refractive index ($n\_H=2,30$) and L being transparent silica oxide with a low refractive index ($n\_L=1,43$), and M a transparent material in the visible part and reflecting in the infra-red part and in which the numbers preceding each of the materials refer to the thickness of the layer of said material (in nanometres), with the layer being repeated (75L/42H) three times.

21. Hybrid system of parametric solar thermal cylinder (14) and photovoltaic receiver (3), according to any of the previous claims, **characterised in that** the number of oxide layers of the spectral separation filter (4) is between 1 and 200.

22. Hybrid system of parametric solar thermal cylinder (14) and photovoltaic receiver (3), according to claim 21, **characterised in that** the number of oxide layers of the spectral separation filter (4) is between 4 and 100 .

23. Hybrid system of parametric solar thermal cylinder (14) and photovoltaic receiver (3), according to claim 22, **characterised in that** the number of oxide layers of the spectral separation filter (4) is between 5 and 20 .

24. Hybrid system of parametric solar thermal cylinder (14) and photovoltaic receiver (3), according to any of the previous claims, **characterised in that** the thickness of the oxide layers (4) is between 1 and 1000 nm .

25. Hybrid system of parametric solar thermal cylinder (14) and photovoltaic receiver (3), according to claim 24, **characterised in that** the thickness of the oxide layers (4) is between 5 and 400 nm .

26. Hybrid system of parametric solar thermal cylinder (14) and photovoltaic receiver (3), according to any of the previous claims, **characterised in that** the primary mirror (1) is in the form of a parabola.

27. Hybrid system of parametric solar thermal cylinder (14) and photovoltaic receiver (3), according to claims 13 or 14, **characterised in that** the active system of thermal management of the photovoltaic receiver (3) comprises:

   - at least one pump
   - at least one fan (15)
   - at least one pipe (16) through which cooling fluid circulates.

28. Hybrid system of parametric solar thermal cylinder (14) and photovoltaic receiver (3), according to claim 19, **characterised in that** the spectral separation filter (4) is a filter with an aperiodic layer design.

29. Hybrid system of parametric solar thermal cylinder (14) and photovoltaic receiver (3), according to claim 28, **characterised in that** the spectral separation filter (4) has an aperiodic design defined by the following sequence:

130L/(162H/262L/164H/261L/159H/250L)/(156H/212L/123H/208L/127H/196L)/142H/

249L/Glass/114L

in which L is $SiO_2$, H is $Nb_2O_5$, and in which the numbers that precede each of the materials refer to the thickness of the layer of said material in nanometres.

FIG. 1

FIG. 2

FIG. 3

FIG. 4

45°

4

45°        45°

## FIG. 5

4

6
6
6
6
6

7

## FIG. 6

9

8

8

## FIG. 7

FIG. 8

FIG. 9

FIG. 10

FIG. 11

FIG. 12

FIG. 13

FIG. 14

FIG. 15

**FIG. 16**

**FIG. 17**

FIG. 18

FIG. 19

## INTERNATIONAL SEARCH REPORT

| International application No |
| --- |
| PCT/ES2014/070999 |

**A. CLASSIFICATION OF SUBJECT MATTER**

INV. F24J2/07   G02B5/28   H01L31/054   H02S40/44
ADD.

According to International Patent Classification (IPC) or to both national classification and IPC

**B. FIELDS SEARCHED**

Minimum documentation searched (classification system followed by classification symbols)

F24J   G02B   H01L   H02S

Documentation searched other than minimum documentation to the extent that such documents are included in the fields searched

Electronic data base consulted during the international search (name of data base and, where practicable, search terms used)

EPO-Internal, WPI Data

**C. DOCUMENTS CONSIDERED TO BE RELEVANT**

| Category* | Citation of document, with indication, where appropriate, of the relevant passages | Relevant to claim No. |
| --- | --- | --- |
| X<br><br>Y | US 2012/279554 A1 (BOSTWICK PAUL ALAN [US]) 8 November 2012 (2012-11-08) paragraphs [0011], [0012], [0016], [0050] - [0059], [0066], [0073], [0074], [0102], [0119]; figures<br>----- | 1,2,4, 7-9,26<br>6,10-12, 16-25, 28,29 |
| X | IMENES A G ET AL: "Spectral beam splitting technology for increased conversion efficiency in solar concentrating systems: a review", SOLAR ENERGY MATERIALS, ELSEVIER SCIENCE PUBLISHERS B.V. AMSTERDAM, NL, vol. 84, 1 October 2004 (2004-10-01), pages 19-69, XP002474546, 5.1- 5.2<br>----- | 1-9,26 |

-/--

| [X] Further documents are listed in the continuation of Box C. | [X] See patent family annex. |
| --- | --- |

\* Special categories of cited documents :

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| 20 April 2015 | 28/04/2015 |

| Name and mailing address of the ISA/<br>European Patent Office, P.B. 5818 Patentlaan 2<br>NL - 2280 HV Rijswijk<br>Tel. (+31-70) 340-2040,<br>Fax: (+31-70) 340-3016 | Authorized officer<br><br>Oliveira, Casimiro |
| --- | --- |

Form PCT/ISA/210 (second sheet) (April 2005)

## INTERNATIONAL SEARCH REPORT

| | International application No |
|---|---|
| | PCT/ES2014/070999 |

C(Continuation). DOCUMENTS CONSIDERED TO BE RELEVANT

| Category* | Citation of document, with indication, where appropriate, of the relevant passages | Relevant to claim No. |
|---|---|---|
| X | EP 0 785 400 A1 (IZUMI HISAO [JP])<br>23 July 1997 (1997-07-23) | 1,2,4,<br>7-9,26 |
| Y | column 1, line 39 - column 4, line 8<br>column 5, line 41 - column 6, line 8;<br>figures | 10,13,<br>14,<br>16-25,<br>27-29 |
| X | EP 0 019 016 A2 (MICHAEL SIMON DIPL ING<br>[DE]) 26 November 1980 (1980-11-26) | 1-3,5,6,<br>9,26 |
| Y | page 6, line 4 - page 7, line 13<br>page 9, line 24 - page 10, line 4; claims;<br>figures | 7,8,10,<br>13,14,<br>16-25,<br>27-29 |
| X | US 4 158 356 A (WININGER DAVID V)<br>19 June 1979 (1979-06-19)<br>column 3, line 60 - column 4, line 63<br>column 5, line 60 - column 6, line 27;<br>figures | 1,2,4,<br>7-9,26 |
| Y | US 4 700 013 A (SOULE DAVID E [US])<br>13 October 1987 (1987-10-13) | 16,17,<br>19,21,<br>24,25,27 |
| A | column 1, line 63 - column 3, line 34<br>column 3, line 59 - line 68; figures | 1,3,5,<br>9-11,13,<br>14 |
| Y | US 2004/031517 A1 (BAREIS BERNARD F [US])<br>19 February 2004 (2004-02-19)<br>6th sentence;<br>paragraph [0019] | 7,8 |
| Y | US 2012/097216 A1 (LIN QINGLONG [FR] ET<br>AL) 26 April 2012 (2012-04-26)<br>paragraphs [0057] - [0060]; figures | 10-15,27 |
| Y | WO 2004/042828 A2 (DAY4 ENERGY INC [CA];<br>OSIPOV ALEXANDER SERGEEVICH [CA]; RUBIN<br>GEORGE L) 21 May 2004 (2004-05-21)<br>figures | 15 |
| Y | CN 203 218 299 U (USTC UNIV SCIENCE TECH<br>CN) 25 September 2013 (2013-09-25) | 6,16-21 |
| A | paragraphs [0005] - [0011]; figure 1 | 5 |
| Y | US 2012/273041 A1 (WU ANGUS [US])<br>1 November 2012 (2012-11-01)<br>paragraphs [0032] - [0036], [0046] -<br>[0048] | 16-25,<br>28,29 |
| Y | US 2012/145220 A1 (WEI CHAO-TSANG [TW] ET<br>AL) 14 June 2012 (2012-06-14)<br>paragraphs [0001] - [0010]; claims;<br>figures | 16-25 |

-/--

Form PCT/ISA/210 (continuation of second sheet) (April 2005)

## INTERNATIONAL SEARCH REPORT

International application No

PCT/ES2014/070999

| C(Continuation). | DOCUMENTS CONSIDERED TO BE RELEVANT | |
|---|---|---|
| Category* | Citation of document, with indication, where appropriate, of the relevant passages | Relevant to claim No. |
| Y | EP 0 632 507 A2 (OPTICAL COATING LABORATORY INC [US]) 4 January 1995 (1995-01-04) page 4, line 4 - page 5, line 28; figures ----- | 16-25, 28,29 |

Form PCT/ISA/210 (continuation of second sheet) (April 2005)

## INTERNATIONAL SEARCH REPORT
Information on patent family members

| International application No |
|---|
| PCT/ES2014/070999 |

| Patent document cited in search report | | Publication date | Patent family member(s) | | Publication date |
|---|---|---|---|---|---|
| US 2012279554 | A1 | 08-11-2012 | AU 2012250840 | A1 | 21-11-2013 |
| | | | CN 103620950 | A | 05-03-2014 |
| | | | EP 2705309 | A2 | 12-03-2014 |
| | | | JP 2014517901 | A | 24-07-2014 |
| | | | SG 194750 | A1 | 30-12-2013 |
| | | | US 2012279554 | A1 | 08-11-2012 |
| | | | WO 2012151215 | A2 | 08-11-2012 |
| EP 0785400 | A1 | 23-07-1997 | AU 707630 | B2 | 15-07-1999 |
| | | | AU 3578895 | A | 02-05-1996 |
| | | | BR 9509220 | A | 27-01-1998 |
| | | | CN 1160441 | A | 24-09-1997 |
| | | | EP 0785400 | A1 | 23-07-1997 |
| | | | KR 100252687 | B1 | 15-04-2000 |
| | | | US 6057504 | A | 02-05-2000 |
| | | | WO 9611364 | A1 | 18-04-1996 |
| EP 0019016 | A2 | 26-11-1980 | DE 2855553 | A1 | 31-07-1980 |
| | | | EP 0019016 | A2 | 26-11-1980 |
| | | | FR 2472146 | A1 | 26-06-1981 |
| US 4158356 | A | 19-06-1979 | NONE | | |
| US 4700013 | A | 13-10-1987 | NONE | | |
| US 2004031517 | A1 | 19-02-2004 | AU 2003259804 | A1 | 25-02-2004 |
| | | | CN 1689158 | A | 26-10-2005 |
| | | | EP 1583925 | A2 | 12-10-2005 |
| | | | US 2004031517 | A1 | 19-02-2004 |
| | | | US 2005091979 | A1 | 05-05-2005 |
| | | | WO 2004015335 | A2 | 19-02-2004 |
| US 2012097216 | A1 | 26-04-2012 | CN 102422440 | A | 18-04-2012 |
| | | | EP 2427919 | A1 | 14-03-2012 |
| | | | FR 2945376 | A1 | 12-11-2010 |
| | | | US 2012097216 | A1 | 26-04-2012 |
| | | | WO 2010128251 | A1 | 11-11-2010 |
| WO 2004042828 | A2 | 21-05-2004 | AU 2003283110 | A1 | 07-06-2004 |
| | | | DE 10251446 | A1 | 19-05-2004 |
| | | | WO 2004042828 | A2 | 21-05-2004 |
| CN 203218299 | U | 25-09-2013 | NONE | | |
| US 2012273041 | A1 | 01-11-2012 | NONE | | |
| US 2012145220 | A1 | 14-06-2012 | TW 201224512 | A | 16-06-2012 |
| | | | US 2012145220 | A1 | 14-06-2012 |
| EP 0632507 | A2 | 04-01-1995 | EP 0632507 | A2 | 04-01-1995 |
| | | | JP H0758355 | A | 03-03-1995 |
| | | | US 5449413 | A | 12-09-1995 |

Form PCT/ISA/210 (patent family annex) (April 2005)

**EP 3 091 307 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090283144 A1